**Europäisches Patentamt**

**European Patent Office**

**Office européen des brevets**

(19)

(11) **EP 0 712 206 A2**

# EUROPEAN PATENT APPLICATION

(12)

(43) Date of publication:
15.05.1996 Bulletin 1996/20

(51) Int. Cl.6: **H03K 17/0812**

(21) Application number: 95202300.0

(22) Date of filing: 24.08.1995

(84) Designated Contracting States:
**DE FR GB**

(30) Priority: **10.11.1994 IT MI942277**

(71) Applicant: **FINMECCANICA S.p.A. AZIENDA ANSALDO**
**I-16128 Genova (IT)**

(72) Inventors:
• **Botto, Guido**
**I-16039 Sestri Levante - Genova (IT)**
• **Bohrer, Wilhelm**
**I-16137 Genova (IT)**

(74) Representative: **Falcetti, Carlo et al**
**c/o JACOBACCI & PERANI S.p.A.**
**Via Visconti di Modrone, 7**
**20122 Milano (IT)**

(54) **A driver system for GTOs**

(57) The driving of a GTO (1) to switch on, off and immediately on again due to failed turn-off is controlled by a finite state logic machine (31,32,33,34) which is timed by a digital timing unit formed of a binary counter (35) and programmable decoders (36,37,38,59,40) of the counter configuration which program the time intervals of turn-on, minimum hold duration, and turn-off.

FIG.1

## Description

Field of the Invention

The present invention relates to a system for driving GTO (Gate Turn-Off) thyristors.

In the making of forced-switching power conversion systems, such as inverters for generating alternating currents and voltages from direct currents and voltages, the use of such late components as GTO thyristors in lieu of traditional thyristors is growing in importance.

Unlike traditional thyristors, GTO thyristors enable an electronic switch to be turned off or opened, as well as turned on.

State of the Art

The control of such electronic switches entails complex operations.

In order to turn them on, the gate electrode must be applied a positive current pulse of predetermined duration and strength.

To hold the switch in the on state, it is necessary that the gate be injected a hold current having a predetermined value, and to turn it off, the gate must be applied a reverse current pulse of particularly great strength and predetermined duration. In addition, several protections are to be provided.

Since GTOs are to operate at a high voltage and a large current, on the order of thousands of volts and amperes, a minimal inductive load component is enough to produce, upon the GTO being turned off, very high overvoltages across the anode and the cathode of the device, which are kept under control by means of so-called snubber RC networks operative to become charged upon turning off the device and discharged during the period that the device is on.

For a snubber to be effective as an overvoltage limiter, it should be in a discharged state when the device is turned off.

Thus, the conduction period of a GTO should be equal to or longer than a predetermined minimum duration that would ensure full discharge of the snubbers, before the next turn-off.

The performance of a GTO at turn-off is particularly critical: in the presence of large currents, the GTO may be turned off only partially, thereby concentrating current on islands not yet reached by the off command.

Should this condition persist, the component is damaged beyond recovery.

One is therefore to ensure, in a known manner and using an indirect measurement of the current across the anode and the cathode (which measurement would be provided by the existing voltage across the gate and the cathode), that the turn-off takes place within a predetermined time, or alternatively, the GTO must be promptly turned on again if permanent damage to it is to be prevented, and the function of cutting off the current be entrusted to fuses or other protection devices.

In inverters, GTOs are usually employed in pairs and turned on in a mutually exclusive manner to connect the common electric node respectively to one or the other of the terminals of an electric DC voltage generator.

Therefore, failure of the GTO to open, as a result of a permanent short or of overloading, should be detected not only to prevent further damage to the thyristor but also to prevent the complementary GTO from closing and shorting the voltage generator.

The protective arrangements further include control of the recognition of command signals, in particular turn-on signals, from external sources.

It should not be overlooked, in this respect, that the electronic control systems for GTOs are connected electrically to the GTO by leads whose length is the shortest possible and operated in an environment where radiated and conducted disturbances of considerable strength exist which are generated by the switching of very large currents, among which can be rated the turn-on/off pulses.

Mistaking a disturbance for a turn-on command may result in a GTO being turned on while its complement is on, leading to catastrophic consequences.

Turn-on control, therefore, should provide for recognition of the command signal at two different time intervals, with a suitable predetermined delay therebetween sufficient to ensure depletion of any disturbance present in the first interval and mistaken for a turn-on command.

To this end, driver systems for GTOs have been developed which provide these control and protection functions and the necessary timing by the use of amplifiers, comparators, and RC networks.

These systems are particularly critical and require accurate setting of their cut-in times in order to be effective.

Further, they are subject to thermal drifting and prone on timing variations due to disturbance.

This enforces the adoption of designing criteria of a conservative type, based on the worst of cases, to ensure adequate safe operation margins in the presence of electric disturbance, which criteria unavoidably result in a slower system response than is desirable.

As an added drawback, these systems must be tailored to the characteristics of the GTOs to be driven, as well as to the conditions of their use, and do not lend themselves for a multipurpose utilization with GTOs of different types and under varying conditions of operation.

Summary of the Invention

The present invention overcomes the above drawbacks and provides a driver system for GTO thyristors which is simple and reliable, highly immune to disturbance and readily programmable to adapt it, in a specific and optimum manner, for the driving requirements of different GTOs in the widest range of operating conditions.

A further feature of this system is its high stability and repeatibility of operation.

According to the invention, these results are obtained by providing the driver system with power circuits which are controlled from a fully digital logic unit implemented as a finite state logic machine timed by a periodic pulsive signal to be generated by a quartz oscillator.

The periodic pulsive signal forms the time base for all the necessary timings provided by a binary counter (as controlled by the periodic pulsive signal) whose outputs are connected to logic gates of recognition of predetermined states of the counter.

In this way, all the control functions are performed using logic circuits of the digital type and restricting the analog functions to the recognition of variable quantities, such as the gate-cathode voltage VGK of the GTO and the system supply voltages, in a continuous fashion.

According to a further aspect of the present invention, the connection between the counter output and the logic gates for recognizing its states is obtained through selectively de-activable links such as small removable straps and microswitches, so as to provide easy programmability for the timing.

According to a further aspect of the present invention, the number of the logic gates for generating the different timings, as well as the counter capacity, are reduced to a minimum, so that the same counter can be used to generate independent turn-on and off timings and the same timing signal can possibly be used for different functions, with the added benefit of making the programming of the different timings independent of one another.

Brief Description of the Drawings

These and other features and the advantages of the invention will be apparent from the following description of a preferred embodiment of the invention and modifications thereof, given with reference to the accompanying drawings, in which:

Figure 1 is a schematic, partly in block diagram form, of a driver system embodying the present invention;
Figure 2 is a timing diagram of the signals developed within the driver system in normal conditions of operation;
Figure 3 is a timing diagram of the signals developed by the driver system on the occurrence of a turn-off malfunction;
Figure 4 is a logic/wiring diagram, partly in block form, of a finite state machine and a timing unit of the system in Figure 1;
Figure 5 is a state evolution flow diagram of the finite state machine shown in Figure 4;
Figure 6 is a state evolution flow diagram of a modification of the finite state machine of the system shown in Figure 1.

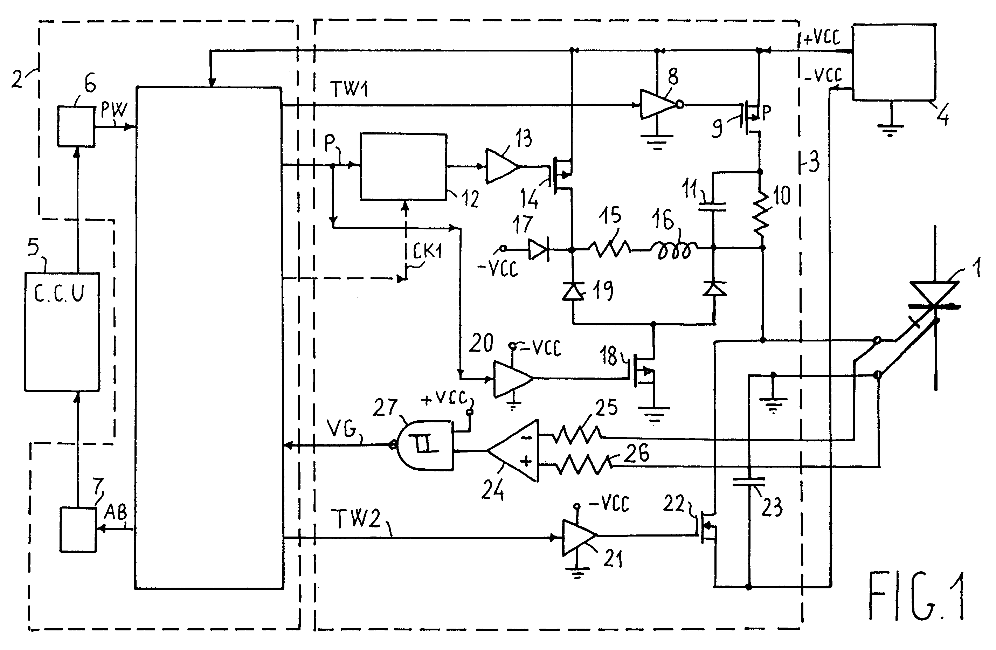

Referring to Figure 1, the driver system for a GTO 1 according to the invention comprises an analog power and measurement section and a digital logic section, preferably making up two printed circuit boards 2 and 3, respectively.

The boards are powered from an external supply 4 which supplies the board 3 with two DC supply voltages +VCC and -VCC (preferably of +15V and -15V, respectively), whereas the logic board 2 is only supplied the voltage +VCC.

The supply 4 is isolated galvanically from the network and clamped to a conventional reference ground equal to the cathode potential of the GTO 1 (which may be variable).

The board 2 supplies the board 3 with a limited number of signals, namely:

- TW1: a signal from the logic unit 2 which controls the GTO 1 turn-on,
- P: a signal from the logic unit 2 which controls the "on" signal of the GTO 1,
- TW2: a signal from the logic unit 2 which controls the GTO 1 turn-off.

These signals are of the logic type and the electric level +VCC suitably corresponds to the asserted state of the signal, while the electric level 0 corresponds to the de-asserted state.

The board 2 can also supply the board 3 with an auxiliary periodic timing signal CK1 at a suitable frequency.

The board 3 sends a signal VG to the board 2, which signal is also of the logic type and, once asserted, indicates that the gate-cathode voltage VGK of the GTO 1 has a higher negative value (in absolute value) than a predetermined threshold, e.g. of -15 volts.

The board 2 communicates with a central control unit CCU 5 by means of a pair of optoisolators or optocouplers 6, 7 which provide galvanic isolation for the driver system.

The optoisolator 6 receives, over fiber optics from the CCU 5, a light signal and converts it into a logic electric signal PW which, when asserted, controls the driver system to turn the GTO 1 on, and when de-asserted, causes the GTO to be turned off.

The duration of the asserted and de-asserted signal PW varies as a function of the partialization that the GTO is to carry out in accord with known pulse-duration modulation techniques.

The optoisolator 7 is activated by a signal AB which, when asserted (at an electric level +VCC), indicates to the CCU 5, by means of a light signal, that the complementary GTO of the GTO driven by the system can be switched on.

The signal TW1 is input to a level amplifier/adapter stage 8 whose output is connected to the gate of a power MOS 9 having a channel of the P type, source electrode connected to the voltage +VCC, and drain electrode connected to the gate of the GTO 1 through a resistor 10 with a capacitor 11 in parallel with the resistor.

When TW1 is asserted, the MOS 9 is closed and a current pulse with a steep leading edge is launched into the gate of the GTO 1.

The pulse width is limited by the resistor 10 and has a predetermined duration dictated by the asserted state of TW1.

With the GTO on, the signal TW1 can be de-asserted, and the hold current, being a lower level, can be applied to the GTO gate through a resistor of appropriate value.

Preferably, in order to avoid dissipating power through resistors, a holding chopper 12 is used which is enabled by the asserted signal P.

The chopper 12 inputs a periodic pulsive signal to the amplifier 13, which signal controls the periodic opening of a P-channel power MOS 14, also with the source electrode connected to the voltage +VCC and drain electrode connected to a series of a resistor 15 and an inductor 16, in turn connected to the gate of the GTO.

To provide a current loop for the inductor 16, when the MOS 14 is open, a diode 17 has its anode connected to the voltage -VCC and cathode connected to the drain of the MOS 14.

Also provided is a re-circulation path activated by the signal P, formed by a MOS 18 with channel of the P type, source electrode connected to ground, and drain connected to the anode of a diode 19 whose cathode is connected to the drain of the MOS 14.

The MOS 18 is controlled by the output signal from an amplifier 20 which is input the signal P.

Throughout the time when P is asserted, the MOS 18 is closed (on).

The GTO 1 is tripped off by the signal TW2 being input to an amplifier 21 whose output is connected to the gate electrode of a MOS 22 (with channel of the N type) having its source electrode connected to the negative voltage -VCC and drain connected to the gate of the GTO 1.

A suitably sized capacitor 23 is permanently connected between ground and the negative voltage source -VCC.

Upon the MOS 22 being closed, the gate of the GTO 1 is applied a very large negative current pulse which turns off the GTO 1.

The state of the GTO is sensed by a differential amplifier 24 having inputs connected to the gate and the cathode of the GTO 1 via appropriate resistors 25, 26.

The output of the amplifier 24 is connected to one input of a logic NAND hysteresis element 27 (Schmitt trigger) which receives the voltage +VCC on a second input and outputs the signal VG.

VG is only asserted (at the electric level +VCC) when the voltage VCC is present and VGK is negative below a predetermined threshold.

During a turn-off operation, having VG asserted within a certain time ensures that the turn-off is actually being carried out and will be completed.

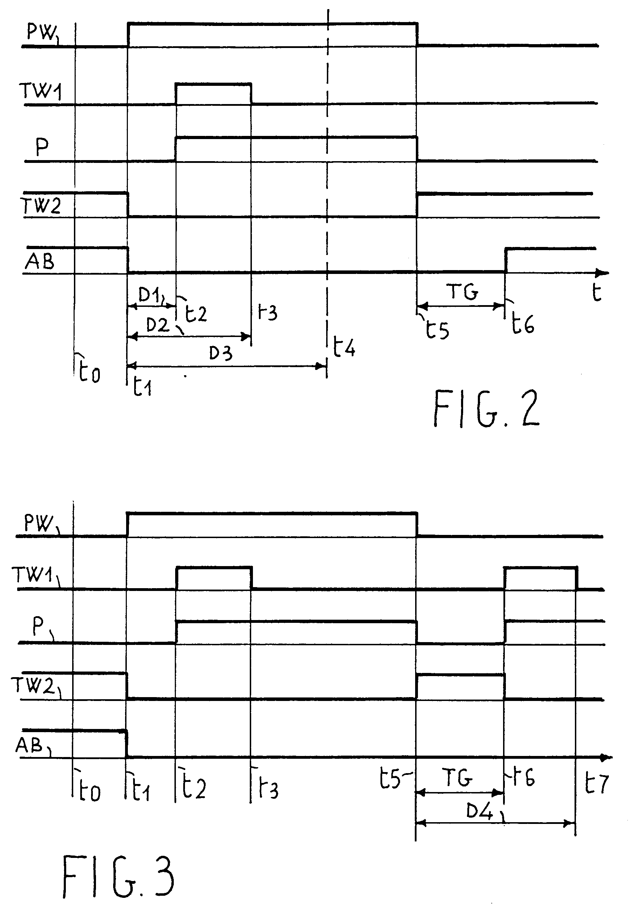

Before describing the logic unit 2 in detail, it pays to consider the timing diagrams of Figure 2 and Figure 3, which describe the operation of the driver system of the present invention, respectively in the instance of regular turning on and off of the GTO and shorting and irregular turning off of the GTO.

With reference to Figure 2, it will be assumed that at an initial time t0 the GTO is off.

The signal TW2 is asserted to hold the gate of the GTO reverse-biased.

The signal AB is asserted to indicate that the complementary GTO may be in the on state.

At a time t1, the central control unit 5 asserts the signal PW. Upon receiving the asserted PW, the driver system de-asserts the signal AB and possibly the signal TW2 as well. To prevent electric disturbance from being mistaken for an asserted signal PW, the state of the signal PW is checked at a time T2 being delayed a suitable time interval D1 from T1.

If PW is still asserted, the driver system asserts the signal P, and for a suitable time interval D2-D1, the signal TW1 as well.

Once the GTO has been turned on, this is to remain on for the time required to discharge the snubber, which time is set by a delay D3.

From this time (t4) onwards, the GTO can be turned off on command from the central control unit with the de-assertion of the signal PW (time t5).

It is apparent that if the de-assertion of PW takes place at an earlier time than t4, the turn-off of the GTO must be differred to the time t4.

At the time t5, the driver system de-asserts P and asserts TW2.

From that time onwards, it should also be checked that, within a predetermined time interval TG, the voltage VGK goes to an adequate negative level and VG is then asserted.

The time interval TG cannot be defined from the time t1 because the duration of the pulse PW is variable.

TG should be measured from t5 (or t4 if t5 precedes t4).

If at a time t6, the GTO turn-off is being carried out correctly, the system asserts the signal AB which will then be ready for a fresh assertion of PW.

Quite different is to be the operation of the driver system if the turn-off is not carried out correctly. In this case, as shown in Figure 3, at the time t6, having checked that VG is de-asserted, the system de-asserts TW2 and asserts TW1 and P.

The signal TW1 should stay asserted through the predetermined time interval (D4-TG)=(D2-D1), on the expiration of which (time t7) P will remain asserted and AB de-asserted.

It therefore is apparent that the signals TW1, P, TW2 and AB should be suitably timed, and that there are two independent timing groups, respectively of turn-on and turn-off or attempted turn-off followed by turn-on again.

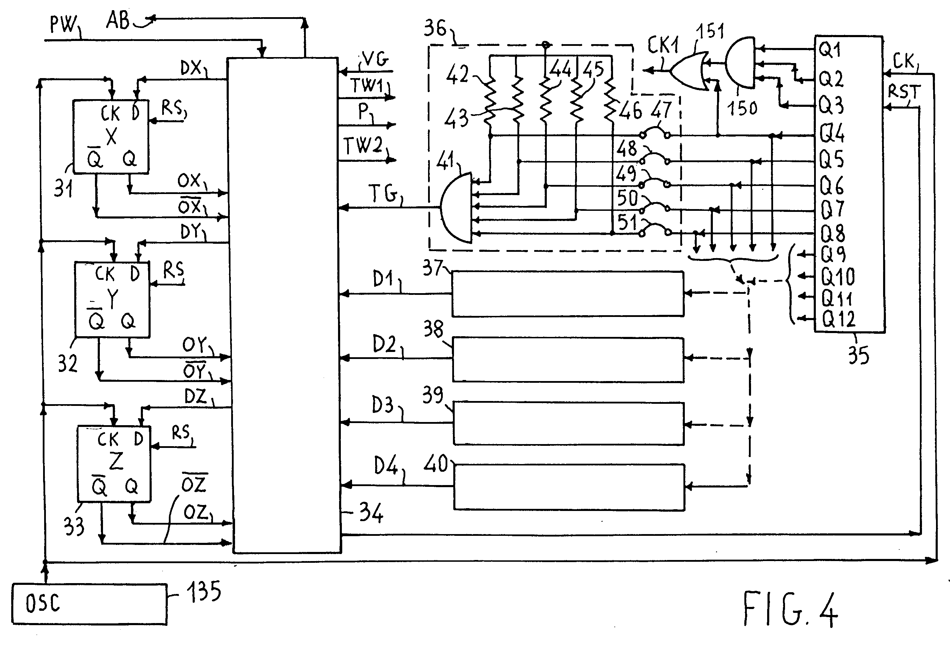

The logic unit 2 which performs these timing and signal generating functions is shown in FIgure 4 and consists of a finite state logic machine associated with a timing unit, also of the digital type.

The logic machine is formed of three flip-flops of the D type, 31, 32, 33 or state flip-flops X, Y, Z, and of AND, OR, INVERTER logic gates which are represented by a single block 34 for simplicity.

The timing unit comprises a clocking oscillator 135, preferably a quartz oscillator, a binary counter 35 (in Figure 4, a 12-bit counter), and a plurality of decoding groups 36, 37, 38, 39, 40.

The group 36 comprises an AND gate 41 having inputs biased at asserted (electric positive) logic level by resistors 42, 43, 44, 45, 46 which are connected to the voltage +VCC.

The inputs of the AND gate 41 are also selectively connected, through removable straps or switches 47, 48, 49, 50, 51, each to one output of the counter 35 which is suitably selected from the different outputs (in Figure 4, the outputs Q4, Q5, Q6, Q7, Q8).

It will be apparent that at the output of the gate 41, an asserted signal TG is only present when all the signals at the outputs Q4 to Q8 are asserted.

The construction of the groups 37, 38, 39, 40 which output the signal D1, D2, D3, D4 is quite similar.

The counter 35 evolves under the effect of a signal CK generated by the oscillator 135 having, for example, a frequency of 4 MHz, and is reset by an asserted signal RST, generated by the group of logic gates 34, according to the state of the flip-flops 31, 32, 33.

It is therefore apparent that the signals TG, D1, D2, D3, D4 are asserted a predetermined time after the time when the counter is activated.

For example, if the period of CK is of 250 ns, the signal TG is asserted $(2^8+2^7+2^6+2^5+2^4) \cdot 250$ ns, i.e. 134 μsec after the counter activation, when all the bridges are present.

The assertion delay of TG can be programmed depending on the straps have been set between $2^4 \cdot 250=4$ μsec and 134 μsec, with a resolution of 4 μsec.

It should be noted that the signal TG, after a first assertion, as a result of the continual evolution of the counter 35, is repeatedly de-asserted and asserted with a period which depends on the connections of the AND gate 41 to the outputs QI of the counter, this leaving the state machine operation unaffected for reasons explained hereinafter.

Similar considerations apply to the signals D1, D2, D3, D4.

The signals TG, D1, D2, D3, D4 are input to the logic gates 34.

These also receive, from the flip-flops 31, 32, 33, the signals OX, OX, Y, OY, Z, OZ present at the respective outputs Q and Q, the signal PW from the optoelectronic isolator 6, and the signal VG from the NAND 27 (Figure 1). Because of typewriting restrictions, the underlining should be taken here as a substitute for the bar which is used to denote the negated level of a signal or of the state of a flip-flop.

The group of logic gates 34 also output, additionally to the signals TW1, P, TW2, AB, signals DX, DY, DZ which are asserted or de-asserted as the case may be and applied to the input D of the flip-flops 31(X), 32(Y), 33(Z).

The flip-flops 31, 32, 33 timed by the clock signal CK are set/reset according to the logic level of the signals DX, DY, DZ.

The flip-flops 31, 32, 33 are reset by an initializing signal RS (upon the driver system being turned on).

The reset state of the flip-flops is an initial wait state of the state machine, or state XYZ.

The state machine can have 8 possible states defined by all the possible combinations of the states of the different flip-flops.

In operation of a state machine, the changeover from one state to another is dependent on the occurrence of events, as represented by signals, but once an event has occurred, the attained state is in general retained even if the event that caused it ends and the signal that caused it is de-asserted.

Clearly, this holds true if repetition of the event is no cause for further changes of state.

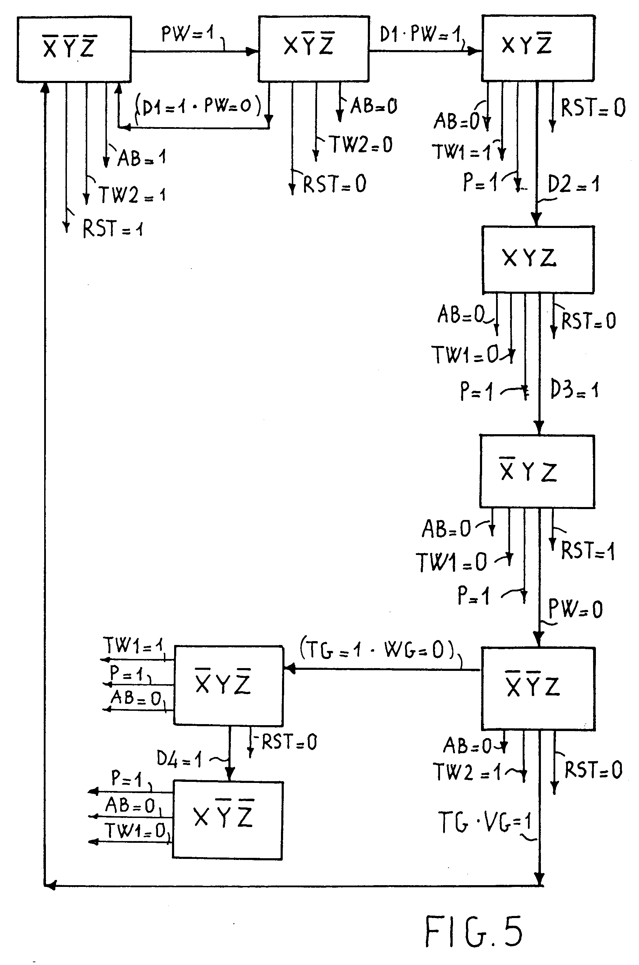

The operation of the state machine can clearly be inferred from the logic flow diagram of Figure 5, which shows the states as blocks and the transitions as arrowheads coming out of one block and pointing into another block.

The transitions are marked with the conditions or events that have caused them.

Also indicated by arrows for each state are the corresponding signals generated by the state machine while in that state.

The constructions and connections of the logic gates 34 are described by the equations below.

The state machine is initially in a reset or XYZ state.

In this state, the machine asserts AB, RST, TW2.

Therefore, the logic gates 34 must operate in conformity with the following equations:

1) If XYZ, then AB=1, RST=1, TW2=1, DY=0, DZ=0.
If XYZ and PW=1, then DX=1, otherwise DX=0.

These equations show that the machine, when in the XYZ state, asserts the signals AB, RST, TW2 while DY and DZ, as input to the flip-flops Y, Z, are de-asserted.

If PW=0, then DX=0 and the machine stays in the inactive state because the clock signal CK upholds the states of the different flip-flops.

The machine goes from the XYZ state to the XYZ state when the flip flop X 31 is set by the clock pulse CK which immediately follows the assertion of the signal PW.

The following equations describe the functions performed by the logic gates and the subsequent state transition.

2) If XYZ, then AB=0, RST=0, TW2=0 DZ=0
If XYZ and D1=1, PW=1 then DX=1, DY=1 otherwise DX=0, DY=0

These equations show that, in the X$\underline{YZ}$ state, the machine activates the counter and de-asserts AB.

Further, if PW is de-asserted at the time t2, the machine is restored to the X$\underline{YZ}$ state, otherwise it goes over to the XY$\underline{Z}$ state.

3) If XY$\underline{Z}$, then AB=0, RST=0, TW1=1, P=1, DX=1, DY=1
If XY$\underline{Z}$ and D2=1, then DZ=1, otherwise DZ=0.

These equations show that, in the XY$\underline{Z}$ state, the machine asserts TW1 and P (RST and AB are still de-asserted) and goes to the XYZ state at the time T3.

4) If XYZ, then AB=0, RST=0, TW1=0, P=1, DY=1, DZ=1
If XYZ and D3=1, then DX=0, otherwise DX=1.

These equations show that, in the XYZ state, the machine de-asserts TW1 (while P is still asserted) and goes over to the $\underline{X}$YZ state at the time t4, t.e. once the snubber is surely discharged.

5) If $\underline{X}$YZ, then AB=0, TW1=0, P=1, RST=1, DX=0, DZ=1
If $\underline{X}$YZ and PW=0, then DY=0, otherwise DY=1.

These equations show that, in the $\underline{X}$YZ state, the counter 35 is reset and held there (while P is still asserted), and the machine goes over to the X$\underline{Y}$Z state if PW is de-asserted.

6) If X$\underline{Y}$Z, then AB=0, RST=0, P=0, TW2=1, DX=0
If X$\underline{Y}$Z and TG=1 and VG=1, then DY=0 and DZ=0
If X$\underline{Y}$Z and TG=1 and VG=0, then DY=0, DZ=1

These equations show that, in the X$\underline{Y}$Z state, the counter 35 is activated to permit counting of the time TG, and that at the time t6 (Figures 2,3), the machine goes over to the $\underline{XY}$Z state or the $\underline{X}$YZ state, according to whether VG is asserted (regular turn-off) or de-asserted (failed turn-off).

It is apparent that, in the $\underline{XY}$Z state, the machine remains awaiting the re-assertion of PW (equation 1).

7) If $\underline{X}$YZ, then TW2=0, TW1=1, P=1, AB=0, RST=0
If $\underline{X}$YZ and D4=1, then DX=1, DY=0

These equations show that, in the X$\underline{Y}$Z state, the counter 35 is still activated (RST=0), TW1 and P1 are asserted, and the X$\underline{Y}$Z state is entered from this state at a time t7 (Flgure 3).

In this state, AB continues to be de-asserted, whereas P is asserted.

The X$\underline{Y}$Z state is a locked state having no outlets, i.e. a deadlock state, from which it is only possible to come out by turning off the driver system and resetting the three flip-flops 31, 32, 33.

A structure of this type offers great advantages over analog circuits currently in use, is virtually immune to disturbance because it operates on the recognition of levels at predetermined time intervals and not of transitions, particularly accurate in the timings, easily programmable to suit the demands and circuit-wise simple and compact, with the logic components being cut down to a minimum.

In particular, two independent series of timing signals can be generated using a single counter.

The foregoing description covers but a preferred embdiment of a state machine, and many changes may evidently be made thereunto.

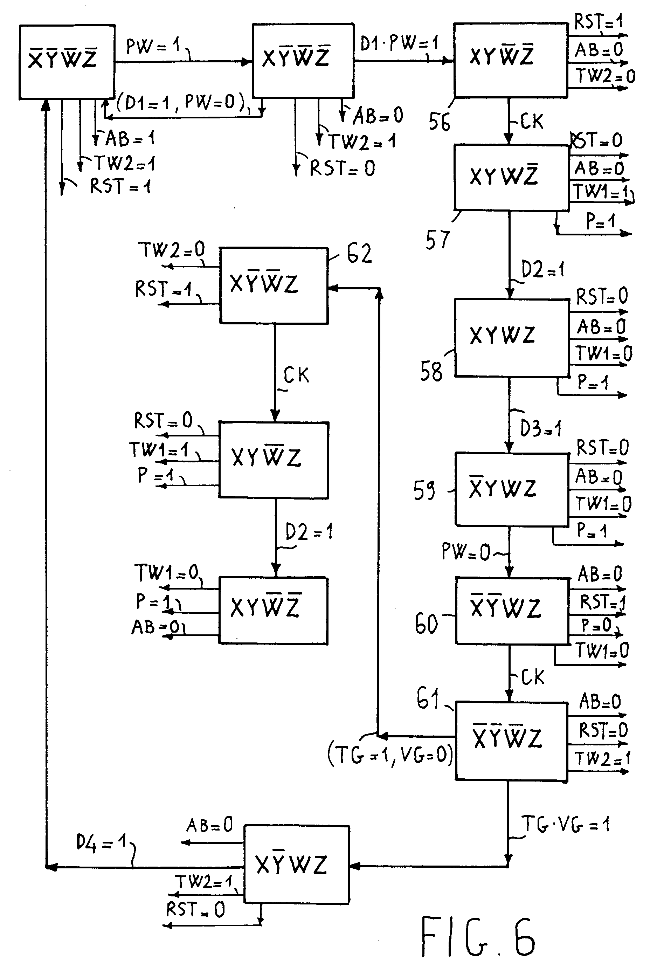

In particular, it is possible to implement, using four flip-flops, a state machine of the same type which is capable of taking more than 8 states, whose logic flow is represented by the block diagram of Figure 6, easy to read and commanding no explanation.

It will just be pointed out that the state machine of Figures 4 and 5 has the following limitations:

- the assertion time of TW1, and hence that of the turn-on, is D2-D1; therefore, any adjustment to T1 implies a correction to D2;
- likewise, the assertion time of TW1 for turning on again is D4-TG, whereby any adjustment to TG implies a correction to T4;
- in order to generate the assertion time of TW1 for turning on again, a different group 40 from the group 38 is needed (in general, TG will be different from D1);
- it is impossible to use the counter 35 as a generator of periodic pulses for partializing the hold current because, in the XY$\underline{Z}$ state wherein the de-assertion of PW is awaited but P is active, the counter 35 would be locked;
- in going from the $\underline{XY}$Z state to the X$\underline{YZ}$ state, the signal propagation times are to inherently ensure advanced opening of the MOS's 9 and 18 (Figure 1) relative to the closing of the MOS 22;
- the enabling of the complementary GTO to go on is supplied to the central control unit as soon as it is verified that the turn-off is being carried out correctly, without waiting for it to be completed.

All these restrictions, however acceptable, are overcome by the state machine of Figure 6, in which:

- D2 is independent of D1 because, on expiration of the time D1, the counter is reset (block 56);
- D2 is used for timing a renewed turn-on immediately after the failed turn-off because, on expiration of the time TG, the counter 35 is reset (block 62);
- the signals TW1 and P are de-asserted to a distinct state from the state to which TW2 is asserted (states 60 and 61).

Since the state passages are synchronous, the assertion of TW2 is inherently delayed, regardless of the propagation delays of the logic and electronic chains, by at least one period of the clock signal, which can be increased by a multiple of the period if the two states are separated by intermediate states.

Finally, the counter 35 may be used as a generator of periodic pulses for partializing the hold current, by keeping the counter active all the time when the signal P is asserted and only commanding its temporary resetting after the de-assertion of PW is recognized (blocks 57, 58, 59, 60). In this way, as shown in Figure 4, a signal CK1 can be extracted from the counter which has a suitable period, being a multiple of the period CK, to control the chopper 12 of Figure 1.

It should be noted that the ON time of CK1 is not necessarily the same as its OFF time.

Using an appropriate logic, also programmable by means of bridges, if desired, the duty cycle of CK1 can be varied. For example, in Figure 4, the logic elements OR 150 and AND 151 allow one to obtain, as connected, a period signal CK1 which is 32 times the period of CK with an ON time of 17/32 that period.

It is then apparent that further modifications may be made.

For example, the timing decoders 36, 37, 38, 39, 40 could have the inputs of the AND gates biased to ground rather than to the positive voltage, and could be formed of logic elements other than the ANDs, such as NORs or combinations of logic elements.

A possible modification consists of also using two or more binary counters with a state machine for timing the different turn-on and off operations independently of one another.

This solution clearly is more expensive in terms of the components required, but is functionally just as effective and can enable a state machine like that shown in Figure 5, which only has 8 states, to generate a signal CK1 effective to partialize the hold current.

In fact, if the turn-on timing is obtained from a first counter, the turn-off timing from a second counter, the first counter can be kept active even in the $\underline{X}\underline{Y}\underline{Z}$ state (while the second counter is, of course, in the reset state) and the second counter be activated to the $\underline{X}\underline{Y}\underline{Z}$ state and subsequent $\underline{X}\underline{Y}\underline{Z}$ and $X\underline{Y}\underline{Z}$ states.

## Claims

1. A GTO thyristor driver system (1) protected against failure of the GTO, wherein a circuit means connected to the cathode and the gate of said GTO controls its on and off states by the respective application of a first current pulse in response to a turn-on command and of a second current pulse, being the reverse of said first pulse, in response to a turn-off command, characterized in that said circuit means comprises:

    a logic state machine (31,32,33,34) timed by a periodic pulsive signal (CK),
    a binary counter (35) activated by said periodic signal (CK), and a plurality of logic gates (41,37,38,39,40) connected to outputs of said counter (35) to recognize a plurality of states of said counter and generate a corresponding plurality of timing signals (D1,D2,D3,TG) which define a time interval of pre-turn-on, turn-on. forced hold, and turn-off, respectively, said timing signals being input to said state machine (31,32,33,34), and said counter being reset and held there by said state machine in at least one predetermined state of said machine.

2. The driver system of Claim 1, wherein said counter (35) is reset and held there by said state machine in at least two predetermined states of said machine.

3. The driver system of either Claim 1 or 2, wherein said logic gates have inputs which are biased electrically through resistors (42,43,44,45,46) and connected to the outputs of said counter (35) by selectively de-activable electric links (47,...,51).

4. The driver system of Claims 1, 2 or 3, wherein said state machine comprises a plurality of flip-flops (31,32,33) timed by said periodic pulsive signal (CK), the combined states of said flip-flops establishing the states of said machine.

5. The driver system of Claim 4, wherein three such flip-flops are provided.

6. The driver system of Claim 1, wherein said counter and said plurality of logic gates generate a periodic switching signal (CK1) for the hold current.

7. The driver system of Claims 1, 2, 3 or 4, wherein the states of said machine include:

    A) an idle wait state,
    B) a state of command confirmation and of partialization,
    C) a state of minimum elapsed turn-on time, and
    D) a state of failed turn-off,
    said counter being reset and held there when said machine is in said states A), B), C), D).

FIG.1

FIG. 2

FIG. 3

FIG.4

EP 0 712 206 A2

FIG.5

FIG. 6